Europäisches Patentamt

European Patent Office

Office européen des brevets

(11) Veröffentlichungsnummer: **0 375 790**

**A1**

(12) **EUROPÄISCHE PATENTANMELDUNG**

(21) Anmeldenummer: **88117046.8**

(22) Anmeldetag: **13.10.88**

(51) Int. Cl.⁵: **H03H 11/12, H03H 11/34**

(43) Veröffentlichungstag der Anmeldung:
**04.07.90 Patentblatt 90/27**

(84) Benannte Vertragsstaaten:
**AT BE DE ES FR GB GR IT LU NL SE**

(71) Anmelder: **Siemens Aktiengesellschaft**
**Wittelsbacherplatz 2**
**D-8000 München 2(DE)**

(72) Erfinder: **Lachmann, Ulrich, Ing. grad.**
**Zirlerstrasse 11**
**D-8000 München(DE)**
Erfinder: **Jasberg, Hartmut, Dipl.-Ing.**
**Putzbrunner Strasse 78**
**D-8012 Ottobrunn(DE)**

(54) **Integrierbare Filterschaltung.**

(57) Integrierbare Filterschaltung mit einem an eine Signalquelle (10) angekoppelten ersten Spannungs-Strom-Wandler (11), mit einem an einen Kondensator (5) angekoppelten zweiten Spannungs-Strom-Wandler (12) und mit einem an den Kondensator (5) angekoppelten Verstärker (14), dessen Ausgang als Filterausgang (4) vorgesehen ist, wobei die Ausgänge der Spannungs-Strom-Wandler (11,12) zueinander gegenphasig auf den Kondensator (5) aufgeschaltet sind.

**FIG 1**

## Integrierbare Filterschaltung

Integrierte Schaltungen für die analoge Signalverarbeitung beinhalten oft Filterschaltungen, um unerwünschte Störgrößen zu unterdrücken. Sehr häufig finden Tiefpässe erster Ordnung, beispielsweise zur Dämpfung hochfrequenter Störanteile, und Hochpässe erster Ordnung beispielsweise zum Abtrennen von Offset-Größen, Verwendung. Die Filterschaltungen werden dabei so ausgelegt, daß zur Grenzfrequenzeinstellung ein möglichst geringer externer Beschaltungsaufwand nötig ist. Da Induktivitäten und Kapazitäten, insbesondere für den Niederfrequenzbereich aufgrund ihrer hohen Werte bisher nur sehr schwierig bwz. überhaupt nicht realisierbar und Induktivitäten allgemein stärker durch Störfelder beeinflußbar sind als Kapazitäten, werden überlicherweise externe Kondensatoren als Elemente zur Grenzfrequenzeinstellung eingesetzt.

In Verbindung mit integrierten ohmschen Widerständen bilden die externen Kondensatoren RC-Glieder, welche direkt als passive Filterschaltung oder im Rückkopplungszweig eines Verstärkers als aktive Filterschaltung zur Anwendung kommen. Passive und aktive Filterschaltungen sind unter anderem aus Tietze-Schenk, Halbleiter-Schaltungstechnik, 5. Auflage 1980, Seite 9 bis 17 und Seite 290 bis 292 bekannt. Mit abnehmender Grenzfrequenz erhöht sich bei einem gegebenen RC-Glied der Widerstandswert und/oder die Kapazität. Da bei einer integrierten Schaltung die Widerstandswerte jedoch nur in begrenztem Maße erhöht werden können, ergeben sich für die externen Kondensatoren erhebliche Kapazitäten bei tiefen Grenzfrequenzen.

Bei vielen Anwendungsfällen stehen aber Kondensatoren höherer Kapazität nicht zur Verfügung oder sind aufgrund ihrer größeren Abmessungen ungeeignet. Beispielsweise werden in der Automobilelektronik aufgrund des großen auftretenden Temperaturbereiches überwiegend Keramikkondensatoren eingesetzt. Diese weisen jedoch nur einen verhältnismäßig geringen Kapazitätsbereich auf.

Aufgabe der vorliegenden Erfindung ist es daher, eine integrierbare Filterschaltung anzugeben, bei der geringere Kapazitäten zur Grenzfrequenzeinstellung benötigt werden.

Die Aufgabe wird bei einer gattungsgemäßen Filterschaltung durch die kennzeichnenden Merkmale des Patentanspruchs 1 gelöst.

Ausgestaltungen des Erfindungsgedanken sind in Unteransprüchen gekennzeichnet.

Die Erfindung wird nachfolgend anhand von den in den Figuren der Zeichnung dargestellten Ausführungsbeispielen näher erläutert. Es zeigt:

FIG 1 ein Blockschaltbild einer grundsätzlichen Ausführungsform einer erfindungsgemäßen Filterschaltung;

FIG 2 ein Schaltbild einer Ausführungsform der erfindungsgemäßen Filterschaltung mit Tiefpaßverhalten;

FIG 3 eine abgewandelte Form der Filterschaltung nach FIG 2 mit Hochpaßverhalten.

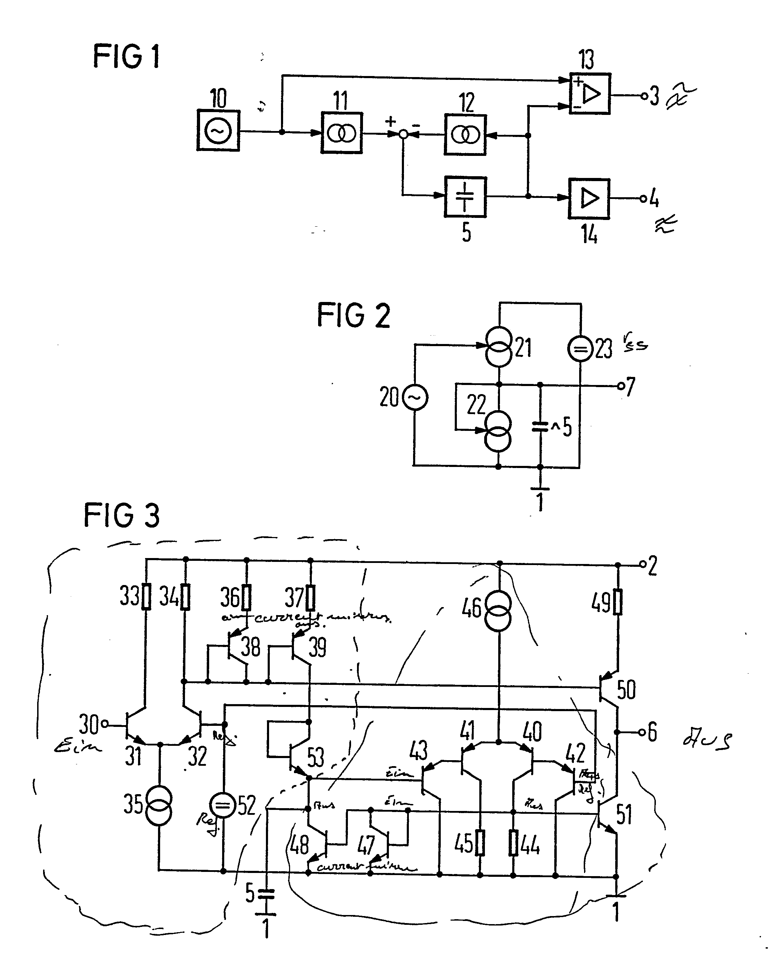

Gemäß FIG 1 sind in einer erfindungsgemäßen Filterschaltung allgemein ein an eine Signalquelle 10 angekoppelter erster Spannungs-Strom-Wandler 11 und ein an einen Kondensator 5 angekoppelter zweiter Spannungs-Strom-Wandler 12 vorgesehen. Die Ausgänge der beiden Spannungs-Strom-Wandler 11, 12 sind zueinander gegenphasig auf den Kondensator 5 aufgeschaltet. Der Ausgang eines eingangsseitig an den Kondensator 5 liegenden Verstärkers 14 bildet den ersten Filterausgang 4. In Ausgestaltung der Erfindung ist als zweiter Filterausgang 3 der Ausgang eines über den nichtinvertierenden Eingang mit der Signalquelle 10 und über den invertierenden Eingang mit dem Kondensator 5 verbundenen Subtrahierverstärkers 13 vorgesehen.

Gemäß der Ausführungsform nach FIG 2 ist der erste Spannungs-Strom-Wandler 11 als spannungsgesteuerte Stromquelle 21 und der zweite Spannungs-Strom-Wandler 12 als spannungsgesteuerte Stromsenke 22 ausgebildet. Die spannungsgesteuerte Stromsenke 22 ist dabei dem Kondensator 5 parallel geschaltet, der mit einem Anschluß auf Bezugspotential 1 und mit dem anderen Anschluß an einem Filterausgang 7 liegt, wobei der Steuereingang der spannungsgesteuerten Stromsenke 22 ebenfalls an den Filterausgang 7 angeschlossen ist. Die spannungsgesteuerte Stromquelle 21, deren Steuereingang mit einem Pol einer Signalquelle 20 beaufschlagt ist, verbindet den Filterausgang 7 mit einem Pol einer Versorgungsspannungsquelle 23. Die anderen Pole von Signal- und Versorgungsspannungsquelle 20, 23 sind jeweils auf Bezugspotential 1 geführt.

Bei der in FIG 3 gezeigten Ausführungsform sind die spannungsgesteuerte Stromquelle 21 und die spannungsgesteuerte Stromsenke 22 nach FIG 2 jeweils als Differenzverstärker mit nachgeschaltetem Stromspiegel ausgebildet. Ein erster Differenzverstärker enthält zwei emittergekoppelte npn-Transistoren 31, 32, eine zwischen das Bezugspotential 1 und den gekoppelten Emittern geschaltete Stromsenke 35 sowie zwei Kollektorwiderstände 33, 34. Die Basis eines Transistors 31 des ersten Differenzverstärkers ist als Eingang 30 der Filterschaltung vorgesehen. Der andere Transistor 32 liegt mit seiner Basis an einem Pol einer auf Bezugspotential 1 führenden Referenzspannungsquelle 52 und mit seinem Kollektor an dem Eingang eines ersten Stromspiegels. Dieser umfaßt im Eingangszweig einen als Diode in Durchlaßrichtung geschalteten pnp-Transistor 38 mit Emitterwiderstand 36 und im Ausgangszweig einen weiteren pnp-Transistor 39 mit Emitterwiderstand 37. Die Emitterwiderstände 36, 37 und die Kollektorwiderstände 33, 34 liegen dabei gemeinsam an einem Versorgungspotential 2. Die Basis des pnp- Transistors 39 ist zusammen mit Basis und Emitter des pnp-Transistors 38 an den Kollektor des npn-Transistors 32 gelegt. Der Kollektor des pnp-Transistors 39 ist in Ausgestaltung der Erfindung über einen als Diode in Durchlaßrichtung geschalteten npn-Transistor 53 mit dem auf Bezugspotential 1 führenden Kondensator 5 verbunden. Dem Kondensator 5 ist der durch die Kollektor-Emitter-Strecke eines npn-Transistors 48 gebildete Ausgangszweig eines zweiten Stromspiegels parallel geschaltet. Der Eingangszweig des zweiten Stromspiegels weist einen als Diode in Durchlaßrichtung geschalteten npn-Transistors 47 auf, der die Basis des npn-transistors 48 mit dem Bezugspotential 1 verbindet. Der Kollektor des npn-Transistors 48 ist mit der einen Eingang des zweiten Differenzverstärkers bildenden Basis eines kollektorseitig auf Bezugspotential 1 liegenden pnp-Transistors 43 verbunden. Der zweite Differenzverstärker umfaßt zwei emittergekoppelte und durch eine Stromquelle 46 von dem Versorgungspotential 2 gespeisten pnp- Transistoren 40, 41 welche jeweils einen auf Bezugspotential 1 führenden Kollektorwiderstand 44, 45 aufweisen. Zwischen die Basis des pnp-Transistors 41 und das Bezugspotential 1 ist die Emitter-Kollektor-Strecke des pnp-Transistors 43 geschaltet. In gleicher Weise liegt auch die Emitter-Kollektor-Strecke eines pnp- Transistors 42 zwischen der Basis des pnp-Transistors 40 und dem Bezugspotential 1. Die Basis des pnp-Transistors 42 ist ebenso wie die Basis des npn-Transistors 32 an die Referenzspannungsquelle 52 angeschlossen.

In Ausgestaltung der Erfindung ist der Subtrahierverstärker 13 nach FIG 1 durch jeweils einen zusätzlichen Ausgangszweig der beiden Stromspiegel und durch die Zusammenschaltung der beiden zusätzlichen Ausgangszweige zu einem gemeinsamen Ausgang 6 realisiert. Dazu ist zum einen die Basis-Emitter-Strecke eines npn-Transistors 51 der Basis-Emitter-Strecke des npn-Transistors 48 parallel geschaltet und zum anderen die Basis eines pnp-Transistors 50, dessen Emitter über einen Emitterwiderstand 49 auf das Versorgungspotential 2 geführt ist, an die Basis des pnp-Transistors 39 angeschlossen. Die Kollektoren des pnp-Transistors 50 und des npn-Transistors 51 sind miteinander verbunden und bilden den Ausgang 6.

Die Funktionsweise einer grundlegenden Ausführungsform gemäß FIG 1 beruht darauf, daß der zur Einstellung der Grenzfrequenz vorgesehene Kondensator 5 mit einem der Spannung der Signalquelle 10 proportionalen Eingangsstrom beaufschlagt ist. Dadurch baut sich am Kondensator 5 eine Spannung mit einer von der jeweiligen Stromrichtung abhängigen Polarität auf. Gleichzeitig wird dem Kondensator 5 aber ein zu der an ihm anliegenden Spannung proportionaler und zu dem Eingangsstrom gegenphasiger Gegenstrom zugeführt, der eine Verringerung der an dem Kondensator 5 anliegenden Spannung bis zum Erreichen eines Gleichgewichtszustandes, bei dem sich beide Ströme aufheben, zur Folge hat. Da der Kondensator 5, wie Kondensatoren allgemein, bei tiefen Frequenzen eine höhere Impedanz aufweist als bei hohen, ist die an ihm abfallende, durch die Differenz von Eingangs- und Gegenstrom hervorgerufene Spannung bei hohen Frequenzen geringer als bei tiefen. Am Ausgang 4 liegt somit das tiefpaßgefilterte Eingangssignal an. Der Verstärker 14 dient dabei bevorzugt zur Impedanzanpassung, kann jedoch auch darüber hinaus zur Erhöhung der Grundverstärkung des Filters eingesetzt werden. Da Stromeinprägungen allgemein, also auch Spannungs-Strom-Wandler, Stromquellen, Stromsenken und Stromspiegel einen hohen Innenwiderstand aufweisen und Stromeinprägungen mit erheblich geringerem Aufwand als hochohmige Widerstände in integrierter Technik zu realisieren sind, sind bei einem erfindungsgemäßen Filter geringere Kapazitäten zur Grenzfrequenzeinstellung nötig.

Wird wie in FIG 1 gezeigt, daß hochpaßgefilterte Signal die Erfindung ausgestaltend von dem Eingangssignal mittels des Subtrahierverstärkers 13 abgezogen oder umgekehrt, so ergibt sich ein hochpaßgefiltertes, am Ausgang 3 anliegendes Eingangssignal. Die Vorteile liegen darin, daß auch bei Hochpaßfilterung nur geringe Kapazitäten und nur ein zusätzlicher Anschluß für den Kondensator 5 zur Grenzfrequenzeinstellung nötig sind.

Neben einer bipolaren Ausführung der Spannungs-Strom-Wandler 11, 12 nach FIG 1 ist in FIG 2 eine unipolare Realisierung dargestellt. Diese sieht beispielsweise eine spannungsgesteuerte Stromquelle 21 zur Ladung des Kondensators 5 und eine spannungsgesteuerte Stromsenke 22 zur Entladung vor. Das am Ausgang 7 auftretende Signal entspricht dem tiefpaßgefilteren Eingangssignal. Im übrigen bringt eine unipolare Ausbildung der Spannungs-Strom-Wandler den Vorteil eines geringeren schaltungstechnischen Aufwandes mit sich.

Desweiteren sind gemäß FIG 3 die Stromquelle 21 bzw. Stromsenke 22 nach FIG 2 als eine Kombination aus Differenzverstärker und Stromspiegel, welche vom Versorgungspotential 2 bzw. vom Bezugspotential 1 aus den Kondensator 5 speisen, ausgeführt. Durch die Erweiterung der Stromspiegel um jeweils einen zusätzlichen Ausgangszweig und duch das Zusammenfassen zu dem gemeinsamen Ausgang 6 der Filterschaltung erfolgt die Subtraktion der von der Eingangsspannung und von der Spannung am Kondensator 5 abhängigen Ströme in den Ausgangszweigen der jeweiligen Stromspiegel. Damit wird vorteilhafterweise mit geringem Aufwand - in dem gezeigten Ausführungsbeispiel nach FIG 3 werden lediglich zwei Transistoren 50, 51 und ein Widerstand 49 zusätzlich benötigt -ein Subtrahierverstärker ausgeführt, an dessen den Ausgang 6 der Filterschaltung bildenden Ausgang das hochpaßgefilterte Eingangssignal anliegt. Um bei geladenem Kondensator 5 Rückströme in den durch den Transistor 39 gebildeten Ausgangszweig des ersten Stromspiegels zu unterbinden, wird in Ausgestaltung der Erfindung der Kollektor des Transistors 39 über einen als Diode in Durchlaßrichtung geschalteten Transistor 53 an den Kondensator 5 geführt.

Abschließend sei bemerkt, daß bei dem Ausführungsbeispiel nach FIG 3 das Versorgungspotential 2 eine positive Polarität gegenüber dem Bezugspotential 1 aufweist. Eine negative Polarität ergibt sich bei Verwendung von Transistoren des jeweils entgegengesetzten Leitungstyps. Darüber hinaus ist eine Realisierung in MOS-Technik ebenfalls möglich.

**Ansprüche**

1. Integrierbare Filterschaltung,
**gekennzeichnet** durch einen an eine Signalquelle (10) angekoppelten ersten Spannungs-Strom-Wandler (11), durch einen an einen Kondensator (5) angekoppelten zweiten Spannungs-Strom-Wandler (12), durch einen an den Kondensator (5) angekoppelten Verstärker (14), dessen Ausgang als Filterausgang (4) vorgesehen ist, und durch eine zueinander gegenphasige Aufschaltung der Ausgänge der Spannungs-Strom-Wandler (11, 12) auf den Kondensator (5).

2. Integrierbare Filterschaltung nach Anspruch 1,
**gekennzeichnet,** durch einen einerseits mit dem Kondensator (5) und andererseits mit der Signalquelle (10) gekoppelten Subtrahierverstärker (13), dessen Ausgang als weiterer Filterausgang (3) vorgesehen ist.

3. Integrierbare Filterschaltung nach Anspruch 1 oder 2,
**dadurch gekennzeichnet,** daß der erste Spannungs-Strom-Wandler (11) als spannungsgesteuerte Stromquelle (21) und der zweite Spannungs-Strom-Wandler als spannungsgesteuerte Stromsenke (22) ausgebildet ist.

4. Integrierbare Filterschaltung nach Anspruch 3,
**dadurch gekennzeichnet,** daß die spannungsgesteuerte Stromquelle (21) als erstern Differenzverstärker (31, 32...35) mit nachgeschaltetem erste Stromspiegel (36, 37, 38, 39) und die spannungsgesteuerte Stromsenke (22) als zweiter Differenzverstärker (40, 41...46) mit nachgeschaltetem zweiten Stromspiegel (47, 48) ausgebildet ist und daß für den ersten Differenzverstärker (31, 32...35) und dem zweiten Stromspiegel (47, 48) Transistoren (31, 32, 47, 48) eines Leitungstyps und für den zweiten Differenzverstärker (40, 41...46) und den ersten Stromspiegel (36, 37, 38, 39) Transistoren (38, 39...43) des anderen Leitungstyps vorgesehen sind.

5. Integrierbare Filterschaltung nach Anspruch 4,
**gekennzeichnet** durch jeweils einen zusätzlichen Ausgangszweig (49, 50, 51) der beiden Stromspiegel (36, 37, 38, 39, 47, 48) und durch die Zusammenschaltung der beiden zusätzlichen Ausgangszweige (49, 50, 51) zu einem gemeinsamen Ausgang (6).

6. Integrierbare Filterschaltung nach Anspruch 3, 4 oder 5, **gekennzeichnet** durch eine der spannungsgesteuerten Stromquelle (31, 32...39) nachgeschalteten Diode (53) in Durchlaßrichtung.

**FIG 1**

**FIG 2**

**FIG 3**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | PATENT ABSTRACTS OF JAPAN, Band 6, Nr. 47 (E-99)[925], 26. März 1982; & JP-A-56 161 711 (SONY K.K.) 12-12-1981 --- | 1 | H 03 H 11/12 H 03 H 11/34 |
| A | EP-A-0 196 883 (SONY CORP.) * Insgesamt * --- | 1 | |
| A | FR-A-2 437 735 (SONY CORP.) * Insgesamt * --- | 1 | |
| A | PATENT ABSTRACTS OF JAPAN, Band 8, Nr. 107 (E-245)[1544], 19. Mai 1984; & JP-A-59 22 424 (TOKYO SHIBAURA DENKI K.K.) 04-02-1984 ----- | 1,4 | |

RECHERCHIERTE
SACHGEBIETE (Int. Cl.5)

H 03 H

Der vorliegende Recherchenbericht wurde für alle Patentansprüche erstellt

| Recherchenort | Abschlußdatum der Recherche | Prüfer |
|---|---|---|
| DEN HAAG | 13-06-1989 | DECONINCK E.F.V. |

EPO FORM 1503 03.82 (P0403)